# EUROPÄISCHE PATENTANMELDUNG

(11) **EP 1 211 769 A2**
(43) Veröffentlichungstag der Anmeldung: **05.06.2002**
(21) Anmeldenummer: 01126429.8
(22) Anmeldetag: 08.11.2001
(51) Int. Cl.: H02B 1/28, H05K 7/20

(54) **Hermetisch dichtes Gehäuse**

(30) Priorität: 29.11.2000 DE 20020270 U
(71) Anmelder: Harting Automotive GmbH & Co. KG, 32339 Espelkamp (DE)
(72) Erfinder: Krause, Jens, Dr.-Ing., 32369 Rahden (DE); Heimann, Thomas, 32339 Espelkamp (DE)
(74) Vertreter: Sties, Jochen, Dipl.-Ing.

(57) **Zusammenfassung**

Die Erfindung betrifft ein hermetisch dichtes Gehäuse für eine Leistungselektronik, mit einer Wanne (10), die aus Stahlblech besteht, und einem Deckel (12), der aus einem Aluminiummaterial besteht, wobei die Wanne einem umlaufenden Rand (28) aufweist, der mit mehreren Biegelaschen (30) versehen ist, und der Rand des Deckels eine Schulter (56) aufweist, an der die Biegelasche (30) anliegt, so daß der Deckel auf den Rand der Wanne gedrückt und eine hermetische Abdichtung erhalten wird.

## Beschreibung

Die Erfindung betrifft ein hermetisch dichtes Gehäuse für die Siedebadkühlung einer Leistungselektronik.

Unter dem Begriff "Leistungselektronik" wird hierbei eine Baugruppe aus mindestens einem elektronischen Bauteil verstanden, in welchem hohe elektrische Leistungen umgesetzt werden, so daß eine große Menge an Verlustwärme anfällt. Diese Verlustwärme muß zuverlässig abgeführt werden, damit es nicht zu einer Überhitzung der Leistungselektronik kommt. Gemäß einer bevorzugten Anwendung des erfindungsgemäßen Gehäuses handelt es sich bei der Leistungselektronik um den Wechselrichter eines sogenannten Starter-Generators, der die bisher getrennt ausgeführten Bauteile Anlasser und Lichtmaschine eines Kraftfahrzeugs vereinigt.

Wenn zur Kühlung die Siedebadkühlung verwendet wird, sind die Bauteile der Leistungselektronik unmittelbar von einer Kühlflüssigkeit umgeben, die von dem Gehäuse aufgenommen ist, in welchem auch die Leistungselektronik angeordnet ist. Vorzugsweise sind die zu kühlenden Bauteile ohne ein Gehäuse ausgeführt, so daß die Kühlflüssigkeit unmittelbar mit den Bereichen des Bauteils in Berührung steht, an denen die Verlustwärme anfällt. Im Falle von Halbleiterchips steht also direkt die Oberfläche des Siliziumchips mit der Kühlflüssigkeit in Verbindung.

Die Kühlflüssigkeit ist so gewählt, daß sie im Betrieb der Leistungselektronik an den Bereichen der Bauteile, in denen die Verlustwärme anfällt, siedet. Die entstehenden Dampfblasen steigen auf und werden an kühleren Abschnitten des Gehäuses kondensiert, so daß wieder als Kühlflüssigkeit für einen neuen Verdampfungsprozeß zur Verfügung stehen. Dieses Kühlungsverfahren ist besonders effektiv, da beim Phasenübergang der Kühlflüssigkeit von flüssig zu dampfförmig eine sehr viel größere Energiemenge aufgenommen wird, als dies bei einer reinen Flüssigkeitskühlung der Fall wäre.

Das Problem bei der Siedebadkühlung besteht darin, daß bei jeder Inbetriebnahme der Leistungselektronik die Temperatur der Kühlflüssigkeit und damit einhergehend der Innendruck im Gehäuse ansteigt. Diese zyklische Druckbeanspruchung stellt eine erhebliche mechanische Belastung des Gehäuses dar. Wenn ein solches Gehäuse für den Einsatz in Kraftfahrzeugen vorgesehen ist, muß gewährleistet sein, daß das Gehäuse auch nach einer Betriebsdauer von 15 Jahren noch dicht ist, da ansonsten eine Kühlung der Leistungselektronik nicht gewährleistet ist. Auch muß das Gehäuse diffusionsdicht sein, da ansonsten die Kühlflüssigkeit trotz intakter mechanischer Abdichtung aus dem Gehäuse austreten könnte.

Die Aufgabe der Erfindung besteht darin, ein Gehäuse für eine Siedebadkühlung einer Leistungselektronik zu schaffen, welches über eine lange Zeitdauer hermetisch dicht ist und dennoch sowohl kostengünstig hergestellt werden kann als auch ein geringes Gewicht aufweist.

Zu diesem Zweck ist erfindungsgemäß ein hermetisch dichtes Gehäuse für die Siedebadkühlung einer Leistungselektronik vorgesehen, mit einer Wanne, die aus Stahlblech besteht, und einem Deckel, der aus einem Aluminiummaterial besteht, wobei die Wanne einen umlaufenden Rand aufweist, der mit mehreren Biegelaschen versehen ist, und der Rand des Deckels eine Schulter aufweist, an der die Biegelasche anliegt, so daß der Deckel auf den Rand der Wanne gedrückt und eine hermetische Abdichtung erhalten wird. Die Verwendung von zwei verschiedenen Werkstoffen für den Deckel und die Wanne bietet eine Reihe von Vorteilen. Die Wanne kann aus Stahl bei niedrigen Kosten mit hoher Festigkeit und hoher Diffusionsdichte gegenüber der Kühlflüssigkeit hergestellt werden, beispielsweise als tiefgezogenes Stahlblechteil. Dieses kann mit geringem Aufwand beispielsweise mit Sicken in den Seitenwänden und am Boden versehen werden, so daß eine hohe Festigkeit gegenüber Belastungen erhalten wird, die aus einem hohen Innenüberdruck im Gehäuse resultieren. Durch die Verwendung von Aluminium oder einer Aluminiumlegierung für den Deckel läßt sich dieser mit einem hohen Wärmeleitvermögen und einer hohen Diffusionsfestigkeit bei noch vertretbaren Kosten herstellen. Die beiden Teile können mit geringem Aufwand miteinander verbunden werden, nämlich durch Umbiegen oder Umbördeln der Biegelaschen; die Biegelaschen haben, da sie ein Teil der aus Stahl bestehenden Wanne sind, automatisch die für das Umbiegen erforderliche Verformbarkeit. Durch die Verwendung von Biegelaschen zur Befestigung des Deckels an der Wanne ergeben sich eine Reihe von Vorteilen. Zum einen ist diese Art der Befestigung prozeßsicher. Wenn die Biegelaschen oben gebogen sind und den Deckel an der Wanne befestigen, ist automatisch gewährleistet, daß die beiden Teile mit der nötigen Kraft aufeinandergepreßt werden, so daß eine gute Dichtwirkung erhalten wird. Anders als beispielsweise bei einem Schweißverfahren ist eine aufwendige nachträgliche Kontrolle nicht erforderlich. Ein weiterer Vorteil der verwendeten Befestigungsart liegt darin, daß die sich im Inneren des Gehäuses befindende Leistungselektronik sowie die Kühlflüssigkeit beim Zusammenfügen von Wanne und Deckel keinen Belastungen ausgesetzt werden und auch keine Verunreinigungen in das Gehäuse eingebracht werden. Anders verhält es sich bei einem Schweißverfahren, bei dem sich sowohl eine hohe thermische Belastung als auch eine Verunreinigung des Inneren des Gehäuses durch Abbrandprodukte ergibt. Schließlich ist die verwendete Befestigungsart sehr vorteilhaft hinsichtlich der Herstellungskosten und der erforderlichen Produktionszeit.

Zur Abdichtung zwischen der Wanne und dem Deckel kann vorteilhafterweise eine Klebstoff-Dichtmasse verwendet werden, die auf den Rand des Deckels oder der Wanne aufgetragen wird und beim Zusammenfügen von Deckel und Wanne größtenteils aus dem Berührspalt heraus verdrängt wird. Die verbleibende dünne Klebstoffschicht bewirkt abgesehen von der gewünschten Abdichtung eine mechanische Verbindung zwischen Wanne und Deckel, da sie sehr scherfest ist. Alternativ zur Klebstoff-Dichtmasse könnte zur Abdichtung auch ein O-Ring oder eine andere Formdichtung verwendet werden, der bzw. die in einer Nut am Rand des Deckels angeordnet ist.

Der Deckel ist auf seiner dem Innenraum des Gehäuses zugewandten Innenseite vorzugsweise mit mehreren Kondensationsrippen versehen, so daß eine möglichst große Fläche für den Wärmeübergang von der Kühlflüssigkeit bzw. der in diesem erzeugten Dampfblasen und dem Deckel des Gehäuses erhalten ist.

Auf seiner Außenseite ist der Deckel vorzugsweise mit einem schlangenlinienförmig verlaufenden Kühlkanal versehen, so daß eine Zwangskühlung der Außenseite des Deckels möglich ist.

Vorteilhafte Ausgestaltungen der Erfindung ergeben sich aus den Unteransprüchen.

Die Erfindung wird nachfolgend anhand einer bevorzugten Ausführungsform beschrieben, die in den beigefügten Zeichnungen dargestellt ist. In diesen zeigen:
- Figur 1 in einer perspektivischen Ansicht ein erfindungsgemäßes Gehäuse;
- Figur 2 in einer perspektivischen Ansicht eine Wanne für das Gehäuse von Figur 1;
- Figur 3 eine Seitenansicht des Gehäuses von Figur 2;
- Figur 4 in vergrößertem Maßstab den Ausschnitt IV von Figur 3;
- Figur 5 eine weitere Seitenansicht des Gehäuses von Figur 2;
- Figur 6 eine schematische Schnittansicht einer in das erfindungsgemäße Gehäuse eingesetzten Isolierplatte;
- Figur 7 in einer perspektivischen Ansicht den Deckel des erfindungsgemäßen Gehäuses zusammen mit einer Abdeckung;
- Figur 8 eine Draufsicht auf den Deckel von Figur 7;
- Figur 9 eine Unteransicht des Deckels von Figur 7;
- Figur 10 den Deckel von Figur 8 in einer Schnittansicht entlang der Ebene X-X von Figur 8;
- Figur 11 den Deckel von Figur 8 in einer Schnittansicht entlang der Ebene XI-XI von Figur 8;
- Figur 12 in vergrößertem Maßstab den Ausschnitt XII von Figur 11; und
- Figur 13 in einer perspektivischen Ansicht das erfindungsgemäße Gehäuse während der Montage.

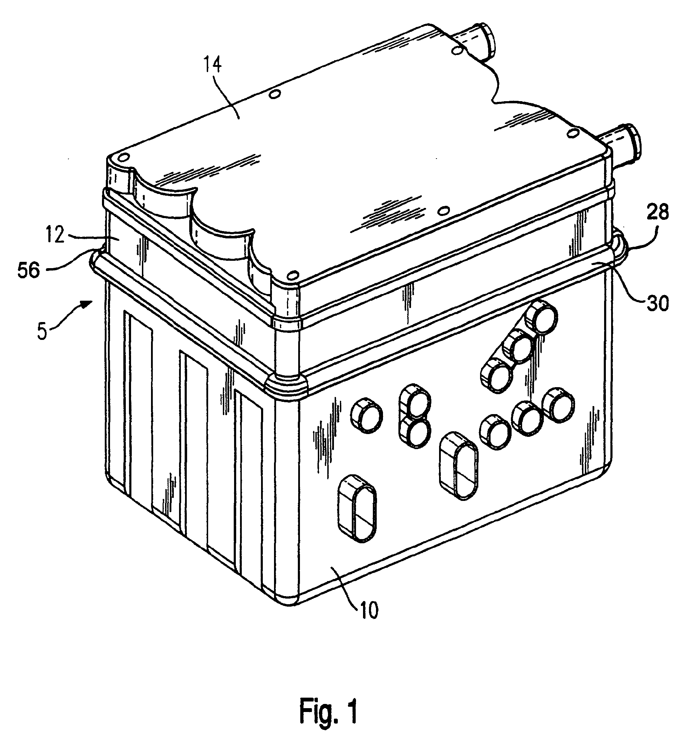

In Figur 1 ist ein Gehäuse 5 gezeigt, das eine Wanne 10, einen Deckel 12 sowie eine auf den Deckel aufgesetzte Abdeckung 14 aufweist.

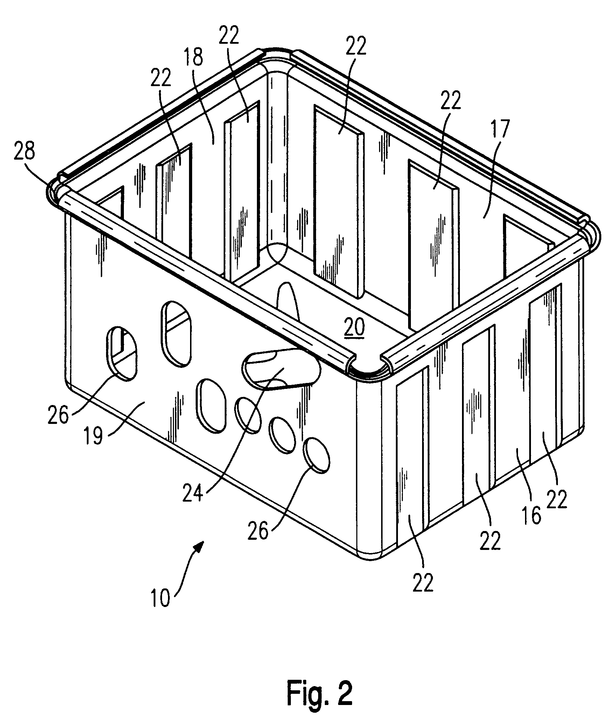

Die Wanne 10 (siehe auch die Figuren 2 bis 6) ist ein tiefgezogenes Stahlblechteil mit einer Wandstärke von etwa 2,5 mm und hat einen rechteckigen Querschnitt mit vier Seitenwänden 16, 17, 18, 19 und einem Boden 20. Die Seitenwände 16, 17, 18 sind mit jeweils drei Sicken 22 versehen, die sich ausgehend vom Boden 20 nach oben erstrecken. Der Boden 20 ist mit einer Kreuzsicke 24 versehen. Die ebene Seitenwand 19, die mit keiner Sicke versehen ist, weist mehrere Aussparungen 26 auf, deren Funktion später erläutert wird.

Die Wanne 10 ist auf ihrer vom Boden 20 abgewandten Seite mit einem umlaufenden Rand 28 versehen, der als über die Seitenwände nach außen hervorstehender Kragen ausgebildet ist. Der Rand 28 ist im Bereich jeder Seitenfläche mit einer Biegelasche 30 versehen, die in Figur 4 in ihrem Ausgangszustand und in den Figuren 2, 3 und 5 in ihrer umgebogenen Form gezeigt sind, in die sie zum Befestigen des Deckels an der Wanne gebracht werden. Dies wird später erläutert.

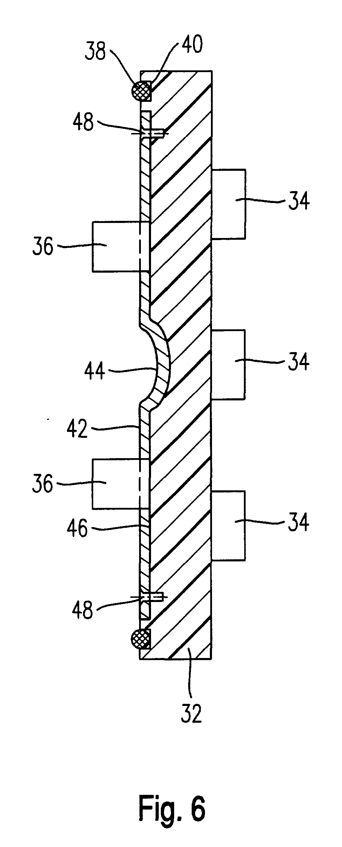

In Figur 6 ist eine Isolierplatte 32 gezeigt, die rechteckig ist und deren Abmessungen etwa denjenigen der Seitenwand 19 entsprechen. Die Isolierplatte 32 besteht aus einem isolierenden Kunststoffmaterial, beispielsweise einem teilkristallinen Kunststoff, und trägt eine Leistungselektronik, die hier nur schematisch durch einige Bauteile 34 gezeigt ist. Die Isolierplatte 32 ist mit mehreren Stromdurchführungen 36 versehen, deren Anordnung auf der Isolierplatte 32 und deren Abmessungen mit der Anordnung und den Abmessungen der Aussparungen 26 in der Seitenwand 19 der Wanne übereinstimmt.

Die Isolierplatte 32 ist mit einer Dichtung 38 versehen, die hier als O-Ring ausgebildet ist, der in einer Nut 40 der Isolierplatte 32 angeordnet ist. Die Nut 40 verläuft im Randbereich der Isolierplatte 32 um die gesamte Isolierplatte herum.

Die Isolierplatte 32 ist auf der Seite der Stromdurchführungen 36 mit einer Verstärkungsplatte 42 versehen, die aus Metall besteht und mehrere Verstärkungssicken 44 aufweist. Die Verstärkungsplatte 42 ist in einer Vertiefung 46 der Isolierplatte 42 aufgenommen und mit der Isolierplatte durch hier schematisch dargestellte Niete 48 verbunden. Die Kontur der Vertiefung 46 entspricht der Oberfläche der Verstärkungsplatte 42 einschließlich der in dieser vorgesehenen Verstärkungssicke 44, so daß die Verstärkungsplatte 42 paßgenau in der Vertiefung 46 aufgenommen ist.

Die Isolierplatte 32 wird in der Wanne 10 so an der Seitenwand 19 angeordnet, daß die Stromdurchführungen 36 sich durch die Aussparungen 26 in der Seitenwand erstrecken; die Leistungselektronik liegt dann auf der Innenseite der Wanne. Die Isolierplatte 32 liegt mit ihrer Dichtung 38 an der Seitenwand 19 an, so daß die Innenseite der Wanne hermetisch gegenüber den Aussparungen 26 abgedichtet ist. Die Isolierplatte 32 kann mit der Seitenwand 19 durch in den Figuren nicht dargestellte Niete oder ähnliche Befestigungsmittel verbunden sein.

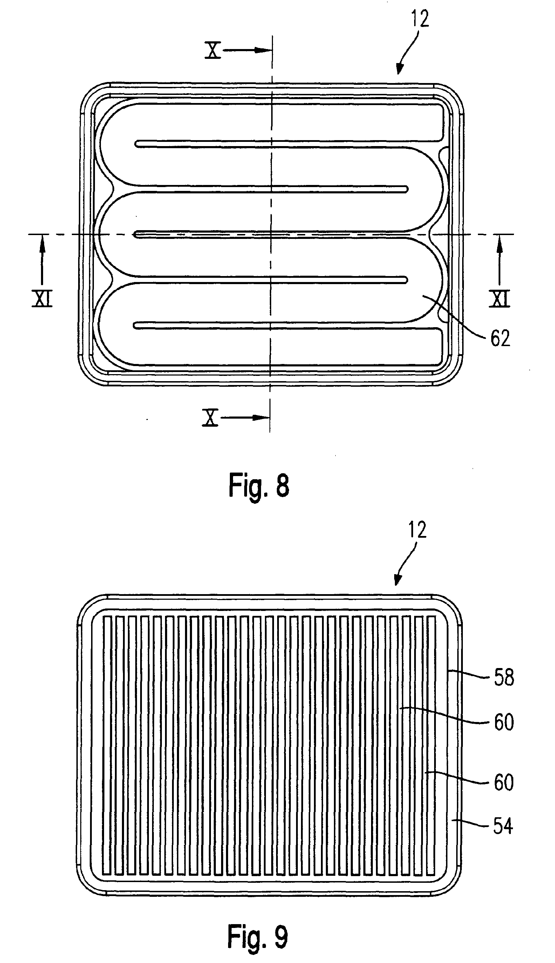

In den Figuren 8 bis 12 ist der Deckel 12 dargestellt, der dafür vorgesehen ist, auf die Wanne 10 aufgesetzt zu werden. Der Deckel 12 ist ein Gußteil aus einer Aluminium-Legierung. Es ist grundsätzlich auch möglich, einen geeignet gegossenen Rohling durch Fließpressen oder ein ähnliches Bearbeitungsverfahren in seine endgültige Form zu bringen.

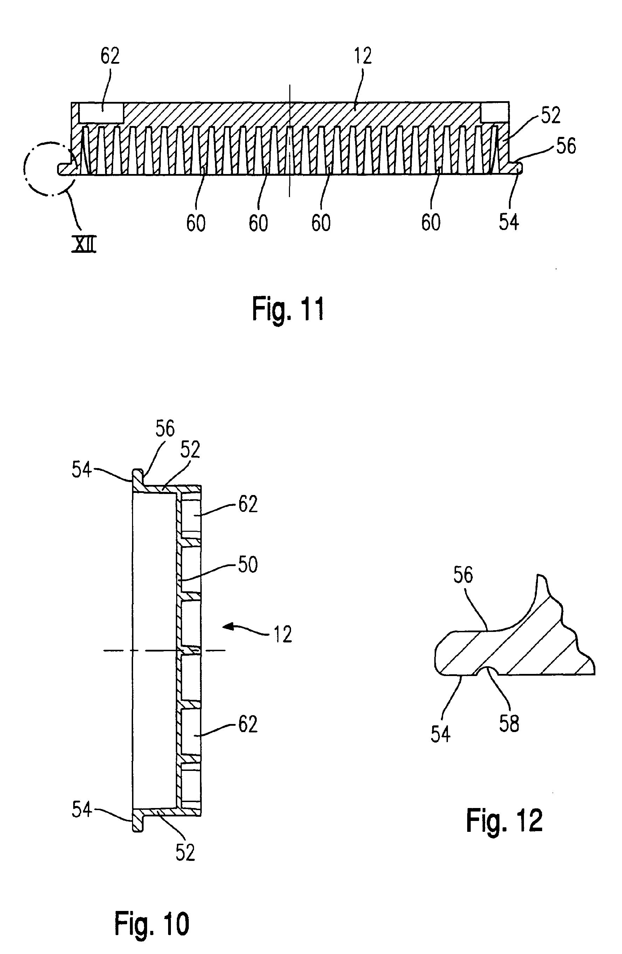

Der Deckel 12 hat denselben rechteckigen Querschnitt wie die Wanne 10 und hat eine kappenförmige Gestalt mit einer Bodenwand 50 und einer umlaufenden Schürze 52. Die Schürze 52 weist einen umlaufenden Rand 54 auf, der mit einer Schulter 56 versehen ist. Auf seiner der Schulter 56 gegenüberliegenden Fläche ist der Rand 52 mit einer umlaufenden Depot-Nut 58 (siehe Figur 12) versehen, deren Funktion später erläutert wird.

Ausgehend von der Bodenwand 50 erstrecken sich zwischen den beiden längeren Seiten der Schürze 52 mehrere Kondensationsrippen 60, die einstückig mit dem Deckel ausgebildet sind.

Auf der vom Rand 54 abgewandten Seite der Bodenwand 50 ist der Deckel 12 mit einem Kühlkanal 62 versehen, der sich schlangenlinienförmig erstreckt. Im Hinblick auf eine leichte Abformbarkeit des Deckels 12 ist der Kühlkanal 62 geschlossen ausgebildet, also mit keinerlei Außenanschlüssen versehen.

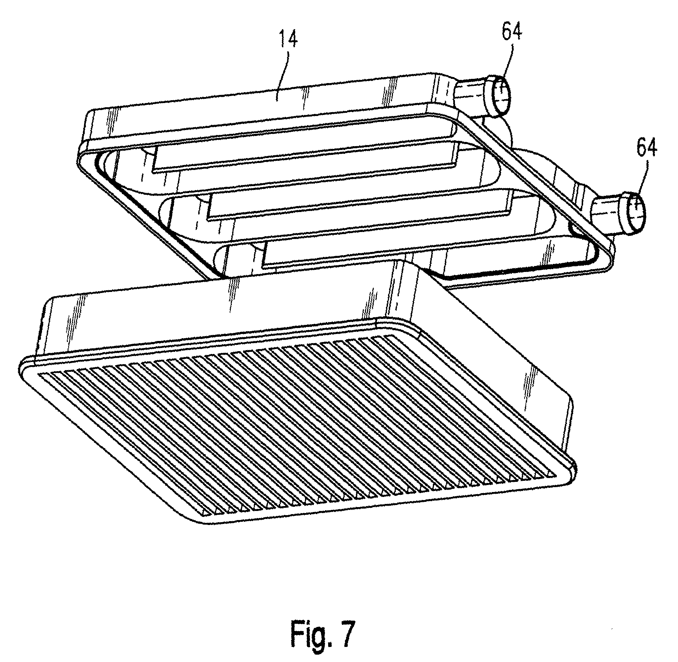

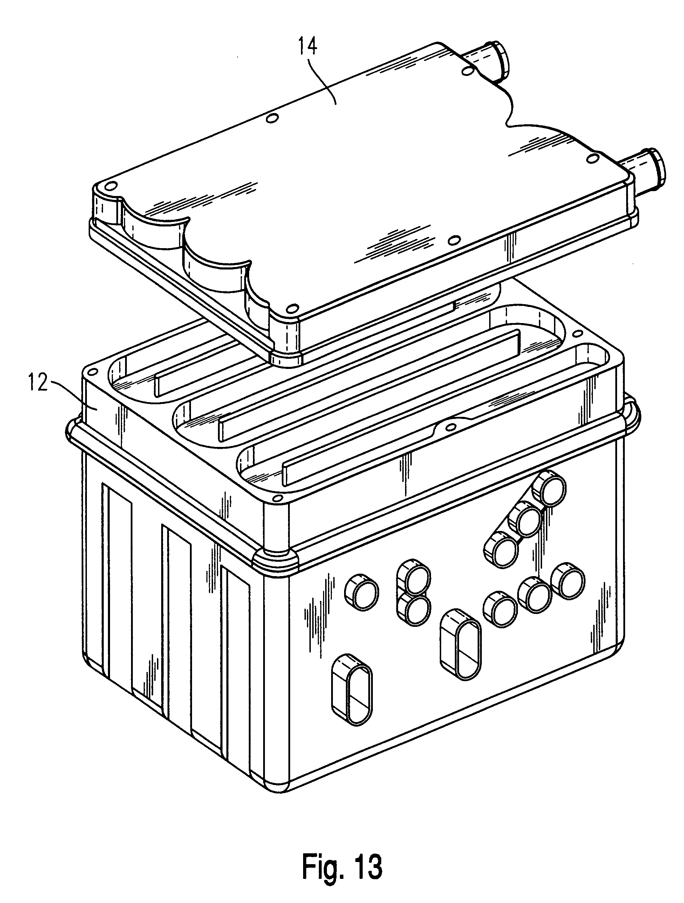

Auf den Deckel 12 wird die Abdeckung 14 (siehe die Figuren 7 und 13) aufgesetzt, die aus Kunststoff besteht. Die Abdeckung 14 ist ebenfalls mit einem Kühlkanal versehen, dessen Verlauf dem Verlauf des Kühlkanals 62 im Deckel 12 entspricht. Die Abdeckung 14 ist weiterhin mit zwei Anschlußstutzen 64 versehen, an die Kühlleitungen angeschlossen werden können, um ein geeignetes Kühlmedium durch den Kühlkanal 62 im Deckel 12 zu leiten.

Die Zusammenbau des Gehäuses erfolgt in der folgenden Weise: Zuerst wird auf der mit der Verstärkungsplatte 42 versehenen Isolierplatte 32 die Leistungselektronik 34 angebracht. Dann wird die Isolierplatte in die Wanne 10 eingesetzt und an der Seitenwand 19 befestigt, so daß die Dichtung 38 der Isolierplatte 32 an der Seitenwand 19 abdichtet. Anschließend wird die Wanne 10 mit der Kühlflüssigkeit gefüllt, die nahezu jede beliebige niedrigsiedende Flüssigkeit sein kann. Besonders geeignet ist Fluorkohlenwasserstoff.

Anschließend wird auf den Rand 54 des Deckels eine Klebstoff-Dichtmasse aufgebracht, wobei auch die Depot-Nut 58 gefüllt wird. Als Klebstoff-Dichtmasse ist jeder Metall-Klebstoff geeignet, mittels dem Stahl und Aluminium verklebt werden können und der beständig gegenüber der verwendeten Kühlflüssigkeit ist.

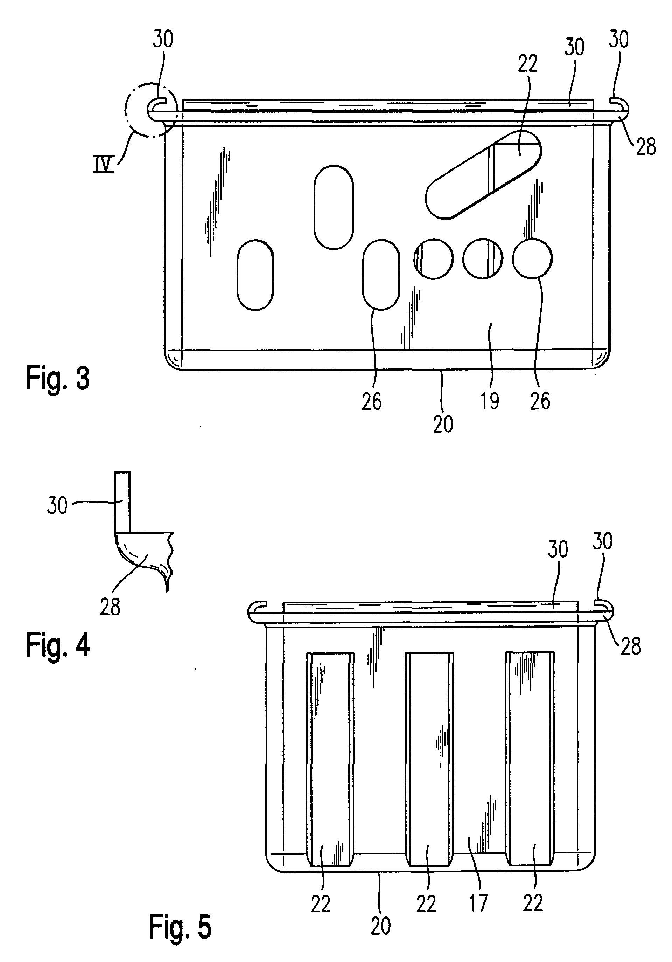

Dann wird der Deckel mit seinem Rand 54 auf den Rand 28 der Wanne 10 aufgesetzt und mit hoher Kraft auf die Wanne aufgedrückt. Dabei wird die Klebstoff-Dichtmasse aus dem Spalt zwischen dem Rand 54 des Deckels und dem Rand 28 der Wanne nahezu herausgedrückt, so daß nur eine dünne Klebstoffschicht übrigbleibt. Zusätzlich ist die Depot-Nut 58 mit dem Klebstoff gefüllt. Anschließend werden die Biegelaschen 30 aus ihrem in Figur 4 gezeigten Zustand in den beispielsweise in den Figuren 3 und 5 sowie Figur 13 gezeigten Zustand umgelegt, so daß sie an der Schulter 56 des Deckels 12 anliegen und diesen fest an der Wanne 10 halten. Auf diese Weise ergibt sich zwischen den Rändern der Wanne und des Deckels eine hermetische Abdichtung, die nach Aushärten des Klebstoffs zusätzlich eine schubfeste mechanische Verbindung darstellt.

Abschließend wird die Abdeckung 14 auf den Deckel 12 aufgebracht und durch Befestigungsschrauben befestigt.

Aufgrund seiner vorteilhaften Konstruktion ist ein Gehäuse erhalten, das sowohl kostengünstig herstellbar ist als auch über eine lange Lebensdauer und eine hohe Druckzyklenzahl hinweg hermetisch dicht ist. Weiterhin wird mit relativ geringem Aufwand eine sehr hohe Steifigkeit erhalten. Die Seitenwände 16, 17, 18 sowie der Boden 20 weisen aufgrund der Sicken 22, 24 eine hohe Steifigkeit gegenüber Belastungen auf, die aus einem Innenüberdruck des Gehäuses resultieren. Auch die Seitenwand 19 weist eine hohe Steifigkeit auf, da die Isolierplatte 32 aufgrund der an ihr angebrachten Verstärkungsplatte 42 eine hohe Steifigkeit aufweist und die Isolierplatte 32 an der Seitenwand 19 nur in deren Außenbereich anliegt, also im Bereich des Bodens, der Seitenwände 16, 18 sowie des Randes 28. Die von der Isolierplatte 32 eingeleitete Druckbelastung führt also nur zu einer geringen Verformung der Seitenwand 19. Der umlaufende Rand 28 trägt durch sein hohes Biegewiderstandsmoment zur großen Steifigkeit der Wanne bei. Auch der Deckel 10 hat aufgrund seiner Gestaltung ein sehr hohes Widerstandsmoment gegenüber Biegebelastungen, die aus einem hohen Innendruck des Gehäuses resultieren. Die Kondensationsrippen 60 verhindern ein Ausbeulen des Deckels durch ihr hohes Biegewiderstandsmoment. Die Schürze 52 trägt zusammen mit der umlaufenden Schulter 56 zu einer hohen Formsteifigkeit bei.

### Bezugszeichenliste:

- 5:: Gehäuse
- 10:: Wanne
- 12:: Deckel
- 14:: Abdeckung
- 16:: Seitenwand
- 17:: Seitenwand
- 18:: Seitenwand
- 19:: Seitenwand
- 20:: Boden
- 22:: Sicke
- 24:: Kreuzsicke
- 26:: Aussparung
- 28:: Rand der Wanne
- 30:: Biegelasche
- 32:: Isolierplatte
- 34:: Leistungselektronik-Bauteile
- 36:: Stromdurchführung
- 38:: Dichtung
- 40:: Nut
- 42:: Verstärkungsplatte
- 44:: Verstärkungssicke
- 46:: Vertiefung
- 48:: Niet
- 50:: Bodenwand
- 52:: Schürze
- 54:: Rand des Deckels
- 56:: Schulter
- 58:: Depot-Nut
- 60:: Kondensationsrippe
- 62:: Kühlkanal
- 64:: Anschlußstutzen

## Patentansprüche

1. Hermetisch dichtes Gehäuse für eine Leistungselektronik, mit einer Wanne (10), die aus Stahlblech besteht, und einem Deckel (12), der aus einem Aluminiummaterial besteht, wobei die Wanne einem umlaufenden Rand (28) aufweist, der mit mehreren Biegelaschen (30) versehen ist, und der Rand des Deckels eine Schulter (56) aufweist, an der die Biegelasche (30) anliegt, so daß der Deckel auf den Rand der Wanne gedrückt und eine hermetische Abdichtung erhalten wird.

2. Gehäuse nach Anspruch 1, **dadurch gekennzeichnet, daß** die Wanne (10) ein tiefgezogenes Stahlblechteil ist.

3. Gehäuse nach einem der vorhergehenden Ansprüche, **dadurch gekennzeichnet, daß** die Wanne einen Boden (20) aufweist, der mit einer Kreuzsicke (24) versehen ist.

4. Gehäuse nach einem der vorhergehenden Ansprüche, **dadurch gekennzeichnet, daß** die Wanne (10) vier Seitenwände (16, 17, 18, 19) aufweist, von denen drei mit mindestens einer Sicke (22) versehen sind.

5. Gehäuse nach einem der vorhergehenden Ansprüche, **dadurch gekennzeichnet, daß** die vierte Wand (19) der Wanne (10) mit mehreren Aussparungen (26) für Stromdurchführungen (36) zur Leistungselektronik versehen ist.

6. Gehäuse nach einem der vorhergehenden Ansprüche, **dadurch gekennzeichnet, daß** im Inneren der Wanne (10) an der vierten Wand (19) eine Isolierplatte (32) angeordnet ist, auf der sich die Leistungselektronik (36) befindet.

7. Gehäuse nach Anspruch 6, **dadurch gekennzeichnet, daß** die Isolierplatte (32) aus einem teilkristallinen Kunststoff besteht.

8. Gehäuse nach einem der Ansprüche 6 und 7, **dadurch gekennzeichnet, daß** die Isolierplatte (32) mit einer Dichtung (38) versehen ist, die sich entlang dem Rand der Isolierplatte erstreckt.

9. Gehäuse nach Anspruch 8, **dadurch gekennzeichnet, daß** die Dichtung ein O-Ring (38) ist, der in einer Nut (40) aufgenommen ist.

10. Gehäuse nach einem der Ansprüche 6 bis 9, **dadurch gekennzeichnet, daß** die Isolierplatte (32) auf ihrer der vierten Wand der Wanne zugewandten Seite mit einer Verstärkungsplatte (42) versehen ist, die aus Metall besteht.

11. Gehäuse nach Anspruch 10, **dadurch gekennzeichnet, daß** die Verstärkungsplatte (42) mit einer Verstärkungssicke (44) versehen ist, die in einer Vertiefung (46) der Isolierplatte liegt.

12. Gehäuse nach einem der Ansprüche 10 und 11, **dadurch gekennzeichnet, daß** die Verstärkungsplatte (42) mit Öffnungen versehen ist, die mit den Aussparungen in der vierten Wand der Wanne korrespondieren.

13. Gehäuse nach einem der Ansprüche 10 bis 12, **dadurch gekennzeichnet, daß** die Verstärkungsplatte (42) mit der Isolierplatte (32) vernietet ist.

14. Gehäuse nach einem der Ansprüche 6 bis 13, **dadurch gekennzeichnet, daß** die Isolierplatte (32) mit der vierten Wand (19) der Wanne (10) vernietet ist.

15. Gehäuse nach einem der vorhergehenden Ansprüche, **dadurch gekennzeichnet, daß** der Deckel (12) aus einer gegossenen Aluminiumlegierung besteht.

16. Gehäuse nach einem der vorhergehenden Ansprüche, **dadurch gekennzeichnet, daß** der Deckel (12) aus einer Aluminium-Knetlegierung besteht.

17. Gehäuse nach einem der vorhergehenden Ansprüche, **dadurch gekennzeichnet, daß** der Deckel (12) mit einem ebenen Rand (54) versehen ist, der auf dem Rand (28) der Wanne (10) aufliegt.

18. Gehäuse nach einem der vorhergehenden Ansprüche, **dadurch gekennzeichnet, daß** sich zwischen dem Rand (28) der Wanne (10) und dem Rand (54) des Deckels (12) eine Klebstoff-Dichtmasse befindet.

19. Gehäuse nach Anspruch 18, **dadurch gekennzeichnet, daß** der Rand (54) des Deckels (12) mit einer Depot-Nut (58) für die Klebstoff-Dichtmasse versehen ist.

20. Gehäuse nach einem der Ansprüche 1 bis 16, **dadurch gekennzeichnet, daß** der Rand des Deckels mit einer Nut versehen ist, in der ein O-Ring angeordnet ist.

21. Gehäuse nach einem der vorhergehenden Ansprüche, **dadurch gekennzeichnet, daß** der Deckel (12) auf seiner Innenseite mit mehreren Kondensationsrippen (60) versehen ist.

22. Gehäuse nach einem der vorhergehenden Ansprüche, **dadurch gekennzeichnet, daß** der Deckel (12) auf seiner Außenseite mit einem Kühlkanal (62) versehen ist, der schlangenlinienförmig verläuft.

23. Gehäuse nach Anspruch 22, **dadurch gekennzeichnet, daß** der Deckel auf seiner Außenseite mit einer Abdeckung (14) versehen ist, die den Kühlkanal verschließt und mit zwei Anschlußstutzen (64) für Kühlleitungen versehen ist.
